# EUROPÄISCHE PATENTSCHRIFT

(11) **EP 0 976 155 B1**
(45) Veröffentlichungstag und Bekanntmachung des Hinweises auf die Patenterteilung: **04.09.2002**
(21) Anmeldenummer: 98907806.8
(22) Anmeldetag: 26.03.1998
(51) Int. Cl.: H01L 23/538, H01L 25/07

(54) **MEHRLAGIGE LEITERPLATTE FÜR HOHE SPANNUNGEN UND HOHE STRÖME SOWIE VERFAHREN ZUR HERSTELLUNG EINER SOLCHEN**
HIGH-VOLTAGE, HIGH-CURRENT MULTILAYER CIRCUIT BOARD, METHOD FOR THE PRODUCTION THEREOF
CARTE DE CIRCUITS MULTICOUCHE POUR TENSIONS ET INTENSITES ELEVEES, ET PROCEDE DE PRODUCTION CORRESPONDANT

(30) Priorität: 27.03.1997 CH 74097
(43) Veröffentlichungstag der Anmeldung: 02.02.2000
(73) Patentinhaber: PPC Electronic AG, 6330 Cham (CH)
(72) Erfinder: STRAUB, Peter, Leo, CH-6317 Oberwil (CH); WÖLM, Rainer, CH-6330 Cham (CH); DIEHM, Peter, CH-6332 Hagendorn (CH); ZEHRINGER, Raymond, W., CH-4132 Muttenz (CH); ETTER, Peter, CH-5422 Oberehrendingen (CH)
(74) Vertreter: Isler & Pedrazzini AG
(86) Internationale Anmeldenummer: CH9800119
(87) Internationale Veröffentlichungsnummer: WO98044557

(56) Entgegenhaltungen:
- EP-A- 0 219 627
- EP-A- 0 430 157
- EP-A- 0 590 324
- EP-A- 0 597 144
- WO-A-92/17045
- PATENT ABSTRACTS OF JAPAN vol. 006, no. 222 (E-140), 6.November 1982 & JP 57 126154 A (NIPPON DENKI KK), 5.August 1982,
- ART DESENA: "Innovative Packages Emerge to Carry Faster, Denser Chips" COMPUTER DESIGN., Bd. 27, Nr. 18, 1.Oktober 1988, LITTLETON, MASSACHUSETTS US, Seiten 35-40, XP000007112

## Beschreibung

### TECHNISCHES GEBIET

Die vorliegende Erfindung bezieht sich auf das Gebiet der Leiterplattentechnik. Sie betrifft eine mehrlagige Leiterplatte für hohe Spannungen und hohe Ströme, bei welcher Leiterplatte eine Mehrzahl von einzelnen Leiterplatten und ersten Isolierplatten in einem Stapel übereinander angeordnet und miteinander fest verbunden sind, wobei innerhalb einer einzelnen Leiterplatte als Leiter jeweils wenigstens eine Metallplatte vorgesehen ist.

Eine solche Leiterplatte ist beispielsweise aus der EP-A1-0 597 144 bekannt und wird dort für den Anschluss einer aus mehreren Einzelmodulen bestehenden hybriden Leistungshalbleiteranordnung verwendet.

Die Erfindung betrifft weiterhin ein Verfahren zur Herstellung einer solchen Leiterplatte.

### STAND DER TECHNIK

Bei Anwendungen in der Leistungselektronik werden zum Verbinden der elektronischen Bauteile Leiterplatten eingesetzt, die insbesondere auch mehrlagig sein können. Wenn mit hohen Wechselspannungen gearbeitet wird - wie dies z.B. bei Hochleistungs-Halbleiterbrücken in Umrichtern oder dgl. der Fall ist - , ergeben sich besondere Anforderungen an den Aufbau bezüglich der Isolation und der Leiter solcher Leiterplatten. Wenn Luft als Isolator verwendet wird, müssen lange Kriechwege und grosse Isolationsabstände zwischen den auf unterschiedlichem Potential befindlichen Leitern vorgesehen werden. Andererseits sollen die Isolationsabstände aber möglichst klein sein, um die Forderung nach niederinduktiven und niederohmigen Verbindungen für hohe Schaltfrequenzen und hohe Schaltströme zu erfüllen.

Die Isolation derartiger Leiterplatten für hohe Ströme und Spannungen sollte dabei möglichst folgende Eigenschaften aufweisen:
- hohe Festigkeit gegenüber thermischen Wechselbelastungen
- Teilentladungsfreiheit
- hohe Spannungsfestigkeit
- Beständigkeit gegenüber Umwelteinflüssen
- luftfreie Umschliessung der Leiterstrukturen
- hohe Delaminationsfestigkeit bei Kurzschlüssen
- gleicher thermischer Ausdehnungskoeffizient wie Leiterstrukturen
- hohe Kriechstromfestigkeit (hoher CTI-Wert)
- Material mit halogenfreiem Flammschutzmittel (UL VO)

In der eingangs genannten Druckschrift ist für den dortigen Anwendungsfall, bei dem Spannungen im Bereich von mehreren kV und Ströme von bis zu 1000 A auftreten können, zum Aufbau des anschlussfertigen Leistunghalbleitermoduls eine Leiterplatte in Form einer Stapelanordnung aus abwechselnd aufeinanderliegenden Isoliermaterialschichten und Leiterbahnschichten verwendet worden. Die Leiterbahnschichten bestehen dabei aus speziell zugeschnittenen Metallplatten, die mit dazwischenliegenden Isolierfolien zu dem Stapel verklebt sind. Der Zuschnitt der Metallplatten erfolgt so, dass für den elektrischen Anschluss aus dem Stapel seitlich Laschen ungeschützt herausragen. Weiterhin sind die Aussenränder und auch die Innenränder der Metallplatten im Stapel zwischen den Isolierschichten zur Seite hin ungeschützt und müssen später mit geeigneten Gussmassen vergossen werden, um die notwendige Isolation gegen die Umwelt zu erreichen.

Es hat sich nun in der Praxis herausgestellt, dass ein solcher einfacher Mehrschichtaufbau aus seitlich offenen Leiterschichten und Isolierschichten gerade bei sehr hohen elektrischen Belastungen (Spannung und Strom) keine ausreichende Beständigkeit und Betriebssicherheit aufweist. Beim nachträglichen Vergiessen lässt sich nicht verhindern, dass sich Lufteinschlüsse im Randbereich der Leiterebene bilden, die bei späteren Belastungen einen Schwachpunkt darstellen.

Bei hohen Spannungen und gleichzeitig kleinen Kriechstrecken bzw. entsprechend ausgelegten Geometrien ist die Feldstärke und somit die Belastung der Isolation ungleich höher als bei heute bekannten Leiterplatten. Gerade die Forderung nach niedriger Induktivität der Stromwege resultiert aber in kleinen Kriechstrecken. Die dielektrische Festigkeit der Isolationsstoffe selbst ist dabei nicht so sehr der kritische Punkt. Vielmehr kritisch ist die Forderung nach einer Vermeidung von Luftspalten, da gerade in diesen die Teilentladung schon bei relativ niedrigen Feldstärken gezündet werden kann.

### DARSTELLUNG DER ERFINDUNG

Es ist daher Aufgabe der Erfindung, eine mehrlagige Leiterplatte für hohe Spannungen und hohe Ströme zu schaffen, die bei gleichzeitiger Einfachheit im Aufbau und in der Herstellung eine hohe Betriebssicherheit auch bei extremen Belastungen gewährleistet, und insbesondere eine hohe Teilentladungsaussetzspannung sowie eine sehr hohe Isolation nach aussen und eine hohe Zuverlässigkeit gegenüber Umwelteinflüssen sicherstellt. Es ist weiterhin Aufgabe der Erfindung, ein Verfahren zur Herstellung einer solchen Leiterplatte anzugeben.

Die Aufgabe wird bei einer Leiterplatte der eingangs genannten Art dadurch gelöst, dass die wenigstens eine Metallplatte jeweils an ihrem Aussenrand über den gesamten Umfang von einer zweiten Isolierplatte formschlüssig umgeben ist. Durch das erfindungsgemässe formschlüssige Umschliessen der Metallplatten mit einer (vorgefertigten) Isolierplatte lassen sich Isolations-Schwachstellen im Aussenbereich der Metallplatten vermeiden bzw. auf ein unschädliches Mindestmass reduzieren. Durch die vollständige Einhüllung der Metallplatten mit Isolation werden die für eine Teilentladung kritischen Luftspalte sicher vermieden, so dass trotz kleiner Kriechstrecken und hoher Betriebsspannungen eine hohe Betriebssicherheit erreicht wird.

Dies gilt insbesondere dann, wenn gemäss einer bevorzugten Ausführungsform die Metallplatten an ihrem Aussenrand mit den zweiten Isolierplatten fest verbunden, insbesondere verklebt, sind. Die Möglichkeit zur Bildung von Lufteinschlüssen wird dadurch auf den engen (typischerweise im 1/10-Millimeterbereich liegenden) Spalt zwischen dem Aussenrand der Metallplatten und dem Innenrand der zweiten Isolierplatten beschränkt. Sie kann durch Auffüllen des Spaltes mit einem Kleber unter Anwendung von Vakuum praktisch ausgeschlossen werden. Es versteht sich dabei von selbst, dass im Rahmen der Erfindung in einer einzelnen Leiterplatte bzw. Leiterebene der mehrlagigen Leiterplatte nicht nur eine Metallplatte sondern mehrere voneinander unabhängige Metallplatten nebeneinander formschlüssig in die zugehörige zweite Isolierplatte eingepasst bzw. "eingebettet" werden können.

Eine zweite bevorzugte Ausführungsform der Leiterplatte nach der Erfindung zeichnet sich dadurch aus, dass die wenigstens eine Metallplatte wenigstens einen von einem Innenrand begrenzten Ausschnitt aufweist, und dass der Innenrand des wenigstens einen Ausschnitts eine dritte Isolierplatte formschlüssig umschliesst. Hierdurch können auch kompliziertere Geometrien der Metallplatte bzw. der einzelnen Leiterplatte verwirklicht werden, welche beispielsweise - wie in der EP-A1-0 597 144 gezeigt - Oeffnungen für die Aufnahme von einzelnen Modulen umschliessen, ohne dass es zu einer Schwächung der Isolation im Bereich der Innenkanten kommt.

Eine dritte bevorzugte Ausführungsform der Erfindung ist dadurch gekennzeichnet, dass die zweiten bzw. dritten Isolierplatten dieselbe Dicke aufweisen wie die Metallplatten. Hierdurch ergibt sich eine kantenloser, glatter Uebergang zwischen den Metallplatten und den Isolierplatten der einzelnen Leiterplatte. Die einzelne Leiterplatte hat damit insgesamt auf der Ober- und Unterseite glatte Oberflächen, die ein flächiges Verkleben der Leiterplatten mit den ersten Isolierplatten im Stapel wesentlich erleichtern und die Gefahr von Fehlstellen zwischen den Platten drastisch verringern.

Eine weitere bevorzugte Ausführungsform der Erfindung zeichnet sich dadurch aus, dass die Metallplatten aus Cu und die ersten und zweiten bzw. dritten Isolierplatten aus einem faserverstärkten Isoliermaterial, vorzugsweise einem gewebeverstärkten Epoxydharz oder einer gewebeverstärkten Keramik, bestehen. Durch eine Faserverstärkung und insbesondere eine Gewebeverstärkung, vorzugsweise mit einem Glasgewebe, im Isolationsmaterial sind alle geometrischen Abmasse, die wesentlich sind für eine eng tolerierte formschlüssige Einpassung der Metallplatten in die zweiten Isolierplatten, genau einstellbar. Das Glasgewebe schützt die Leiterplatte vor Delaminationen bei extrem hohen Strömen (im Kurzschlussfall: 500 kA!). Weiterhin erreicht man mit einem solchen Aufbau eine hohe Stabilität und auch eine hohe Beständigkeit gegenüber von Umwelteinflüssen (Temperatur, Luftfeuchtigkeit, Chemikalienbeständigkeit).

Das erfindungsgemässe Verfahren zum Herstellen einer mehrlagigen Leiterplatte ist dadurch gekennzeichnet, dass in einem ersten Schritt die durch einen Aussenrand mit vorgegebener Randkontur begrenzten Metallplatten und die mit einem durch einen Innenrand mit entsprechender Randkontur begrenzten Ausschnitt zur formschlüssigen Aufnahme der Metallplatten versehenen zweiten Isolierplatten bereitgestellt werden, dass in einem zweiten Schritt die Metallplatten jeweils in den dafür vorgesehenen Ausschnitt der entsprechenden zweiten Isolierplatte eingepasst werden und zusammen mit der entsprechenden zweiten Isolierplatte jeweils eine einzelne Leiterplatte bilden, und dass in einem dritten Schritt die so gebildeten einzelnen Leiterplatten zusammen mit ersten Isolierplatten in einem Stapel angeordnet und miteinander fest verbunden werden.

Eine bevorzugte Ausführungsform des Verfahrens nach der Erfindung zeichnet sich dadurch aus, dass die Metallplatten mit den zweiten Isolierplatten vor dem dritten Schritt zur Bildung einer einheitlichen einzelnen Leiterplatte randseitig miteinander verklebt werden, und dass die randseitige Verklebung unter Vakuum erfolgt. Hierdurch werden die Spalte zwischen den Metallplatten und den zweiten Isolierplatten praktisch defektfrei verfüllt und die resultierende einzelne Leiterplatte bildet eine kompakte, stabile Einheit, die sich im nachfolgenden Fertigungsschritt der Stapelbildung leicht und sicher handhaben lässt.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden.

Es zeigen
- Fig. 1a,b: ein erstes Exemplar einer für ein erstes bevorzugtes Ausführungsbeispiel der Erfindung vorgesehenen zweiten Isolierplatte vor (Fig. 1a) und nach (Fig. 1b) dem Einbringen des Ausschnitts, welcher für die formschlüssige Aufnahme einer Metallplatte vorgesehen ist;
- Fig. 2a,b: eine für die Aufnahme in die Isolierplatte nach Fig. 1 vorgesehene Metallplatte mit angepasster Randkontur (Fig. 2a) und zusätzlich eingebrachten Ausschnitten (Fig. 2b);
- Fig. 3a-c: ausgehend von der vorbereiteten Metallplatte nach Fig. 2b (Fig. 3a) die einzelnen Isolierplatten (Fig. 3b), welche zur Isolierung des Innenrandes in die Ausschnitte der Metallplatte formschlüssig eingesetzt werden (Fig. 3c);
- Fig. 4: die mit den Isolierplatten nach Fig. 1b und Fig. 3b und der Metallplatte nach Fig. 2b gebildete einzelne Leiterplatte;
- Fig. 5a,b: ein zweites Exemplar einer für erste bevorzugte Ausführungsbeispiel der Erfindung vorgesehenen zweiten Isolierplatte vor (Fig. 5a) und nach (Fig. 5b) dem Einbringen des Ausschnitts, welcher für die formschlüssige Aufnahme einer Metallplatte vorgesehen ist;
- Fig. 6a,b: eine für die Aufnahme in die Isolierplatte nach Fig. 5 vorgesehene Metallplatte mit angepasster Randkontur (Fig. 6a) und zusätzlich eingebrachten Ausschnitten (Fig. 6b);
- Fig. 7a-c: ausgehend von der vorbereiteten Metallplatte nach Fig. 6b (Fig. 7a) die einzelnen Isolierplatten (Fig. 7b), welche zur Isolierung des Innenrandes in die Ausschnitte der Metallplatte formschlüssig eingesetzt werden (Fig. 7c);
- Fig. 8: die mit den Isolierplatten nach Fig. 5b und Fig. 7b und der Metallplatte nach Fig. 6b gebildete einzelne Leiterplatte;
- Fig. 9: in der perspektivischen Explosionsdarstellung die den Stapel des Ausführungsbeispiels bildenden einzelnen Leiterplatten gemäss Fig. 4 und Fig. 8 und ersten Isolierplatten;
- Fig. 10: im Schnitt den Aufbau eines zur EP-A1-0 597 144 vergleichbaren Hybridmoduls mit der mehrlagigen Leiterplatte gemäss Fig. 9, und
- Fig. 11: in der perspektivischen Schnittansicht ein anderes Ausführungsbeispiel für eine Leiterplatte nach der Erfindung mit zusätzlichen Durchkontaktierungen, isolierten Befestigungsbohrungen und einem Kühlelement.

### WEGE ZUR AUSFÜHRUNG DER ERFINDUNG

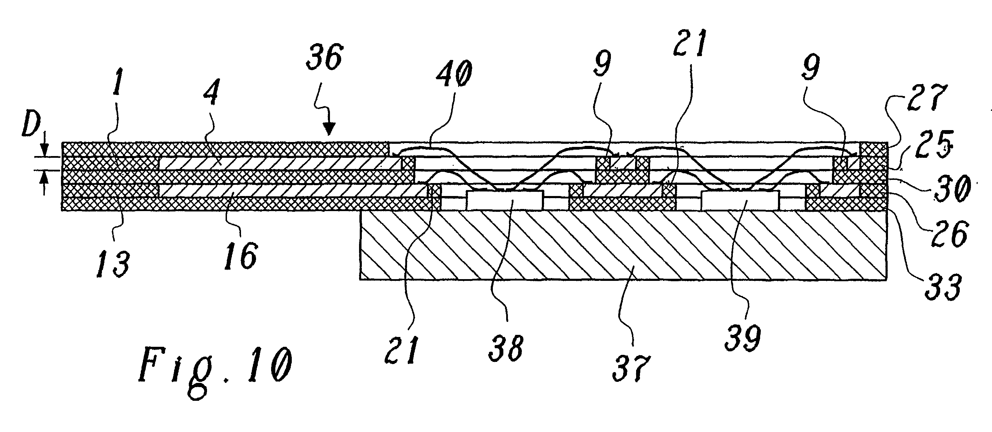

In Fig. 10 ist im Schnitt der Aufbau eines zur EP-A1-0 597 144 vergleichbaren Hybridmoduls mit einer mehrlagigen Leiterplatte gemäss einem bevorzugten Ausführungsbeispiel der Erfindung dargestellt. Die mehrlagige Leiterplatte 36 dient als elektrischer Anschluss für eine Mehrzahl von einzelnen Halbleiter-Leistungsmodulen 38, 39, die auf geeignete Weise und untereinander beabstandet auf einem thermisch gut leitenden plattenförmigen Kühlkörper 37 angeordnet sind. Die Leiterplatte 36 besteht aus einem mehrlagigen Stapel ganzflächig miteinander verklebter Platten, wobei Isolierplatten 27, 30, 33 mit einzelnen Leiterplatten 25, 26 abwechseln. Jede der einzelnen Platten 25 bis 27 und 30, 33 hat im Bereich der Halbleiter-Leistungsmodule 38, 39 entsprechende Ausschnitte, so dass in der Leiterplatte 36 Ausnehmungen entstehen, durch welche die Module von oben einsetzbar und zugänglich sind. Die einzelnen Platten 25 bis 27 und 30, 33 sind im Beispiel Fig. 10 mit derselben Dicke D dargestellt. Es versteht sich von selbst, dass je nach den Anforderungen die Isolierplatten 27, 30, 33 und die einzelnen Leiterplatten 25, 26 voneinander abweichende Dicken haben können. So kann für besonders hohe Ströme die Dicke der einzelnen Leiterplatten 25, 26 grösser gewählt werden; es kann aber auch für besonders hohe Spannungen die Dicke der Isolierplatten 27, 30, 33 grösser gewählt werden. Die Dicke D der einzelnen Leiterplatten beträgt typischerweise 1,5 mm.

Die einzelnen Leiterplatten 25, 26 enthalten jeweils eine oder mehrere Metallplatte(n) 4 bzw. 16, welche die Funktion der Stromleitung übernehmen innerhalb der mehrlagigen Leiterplatte 36 übernehmen. Die Metallplatten 4, 16 haben vorzugsweise dieselbe Dicke D wie die einzelnen Leiterplatten 25, 26. Die erfindungsgemässe Besonderheit besteht nun darin, dass die Metallplatten 4, 16 nicht ungeschützt zwischen den Isolierplatten 27, 30, 33 angeordnet und mit diesen verklebt sind, sondern dass sie jeweils an ihren Rändern, sowohl den Aussenrändern als auch möglichen Innenrändern, formschlüssig von einer Isolierplatte 1 bzw. 13 gleicher Dicke umschlossen sind (Aussenränder) bzw. Isolierplatten 9 bzw. 21 formschlüssig umschliessen (Innenränder). Jede einzelne Leiterplatte 25, 26 ist also aus einer oder mehreren Metallplatten 4 bzw. 16 und entsprechenden Isolierplatten 1, 9 bzw. 13, 21 aufgebaut, die mit enger Toleranz formschlüssig ineinandergreifen und an den Kanten miteinander sorgfältig verklebt sind. Auf diese Weise sind die Metallplatten 4, 16 im Stapel der mehrlagigen Leiterplatte 36 vollständig eingebettet und gegen schädliche Umwelteinflüsse stabil und sicher geschützt. Durch die Einbettung werden insbesondere Luftspalte zwischen den Metallplatten vermieden, die bei hohen Feldstärken zu unerwünschten Teilentladungen führen und die Betriebssicherheit der Leiterplatte beinträchtigen könnten.

Die Metallplatten 4, 16 bestehen vorzugsweise aus Cu und sind - wie bereits erwähnt - typischerweise 1,5 mm dick, können aber auch andere Dicken aufweisen. Die Isolierplatten 1, 9 bzw. 13, 21, wie auch die Isolierplatten 27, 30, 33 sind vorzugsweise aus einem faserverstärkten Isoliermaterial. Die Faserverstärkung sorgt dabei insbesondere für eine massgenaue Bearbeitbarkeit und eine hohe mechanische Stabilität, sowie einen der Metallplatte (Cu) angepassten thermischen Ausdehnungskoeffizienten.

Bewährt haben sich insbesondere Isolierplatten aus Epoxydharz mit Glasgewebeverstärkung oder mit einer Verstärkung aus nichtverwobenen Aramidfasern, wie sie im Handel unter der Bezeichnung Duraver-E-Cu 104ML, Duraver-E-Cu 116ML oder Duramid-P-Cu 115ML von der Firma Isola erhältlich sind. Ebenfalls bewährt haben sich Isolierplatten aus einer mit Glasgewebe verstärkten Keramik, wie sie z.B. unter der Bezeichnung RO4003/RO4350 von der Firma Rogers angeboten werden. Die Verklebung an den Kanten zwischen Metall- und Isolierplatte ermöglicht bei geeigneter Wahl des Klebers und der Spaltbreite einen Ausgleich von unterschiedlichen thermischen Ausdehnungen zwischen Metall und Isoliermaterial. Als Kleber bewährt haben sich beispielsweise handelsübliche thermisch aushärtbare Epoxydharzkleber. Bei der Wahl der Spaltbreite bzw. der Toleranz des Formschlusses ist insbesondere zu berücksichtigen, dass bei gewebeverstärkten Isolierplatten wegen der Webart (Kette und Schuss) in unterschiedlichen Richtungen unterschiedliche Ausdehnungskoeffizienten (z.B. 16 ppm/K in x-Richtung gegenüber 11 ppm/K in y-Richtung beim Duraver-E-Cu 116ML) auftreten können, die entsprechend unterschiedliche Spaltbreiten erforderlich machen.

Die Verbindung zwischen den Halbleiter-Leistungsmodulen 38, 39 und den Metallplatten 4, 16 (den Leiterbahnen) der mehrlagigen Leiterplatte 36 wird beispielsweise über Anschlusslaschen 40 hergestellt, die am einen Ende auf die Module gelötet oder gebonded sind, und am anderen Ende die in Kontakt mit den Metallplatten 4, 16 stehen. Der Plattenstapel ist dazu im Bereich der Ausnehmungen für die Module stufenartig aufgebaut, so dass gewisse Randbereiche der Metallplatten 4, 16 mit der Oberfläche frei liegen und mit den Anschlusslaschen 40 elektrisch verbunden werden können.

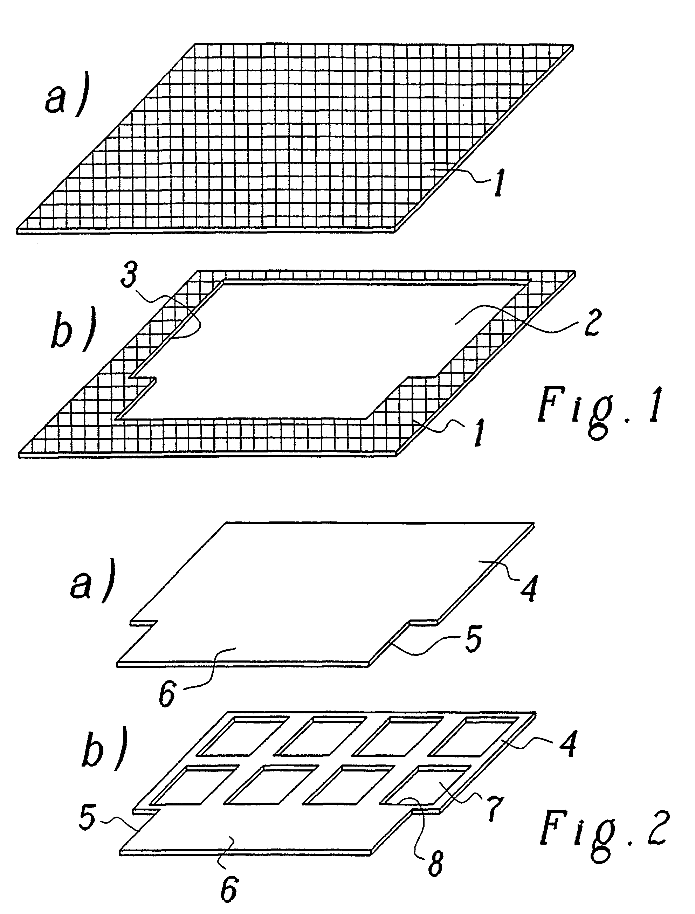

Die Herstellung der mehrlagigen Leiterplatte 36 gemäss Fig. 10 erfolgt im Rahmen der Erfindung bevorzugt in der in Fig. 1 bis 9 gezeigten Weise. Zur Herstellung der einzelnen Leiterplatte 25 wird gemäss Fig. 1 zunächst von einer vollflächigen (gewebeverstärkten) Isolierplatte 1 ausgegangen (Fig. 1a), in welche durch ein geeignetes Bearbeitungsverfahren (Fräsen, Schneiden, Sägen, Laserschneiden oder dgl.) ein Ausschnitt 2 eingebracht wird, der vollständig von der Isolierplatte 1 umschlossen ist und durch einen Innenrand 3 begrenzt ist (Fig. 1b). Die Randkontur des Innenrandes 3 entspricht möglichst formgetreu und genau der Randkontur des Aussenrandes der Metallplatte (4 in Fig. 2), die später in den Ausschnitt 2 eingefügt werden soll. Werden in der Leiterplatte nebeneinander mehrere unabhängige Leiter bzw. Metallplatten vorgesehen, müssen anstelle des einen Ausschnittes 2 entsprechend mehrere Ausschnitte in die Isolierplatte 1 eingebracht werden.

In gleicher Weise wird gemäss Fig. 2 eine entsprechende Metallplatte 4, die vorzugsweise dieselbe Dicke aufweist wie die Isolierplatte 1, so bearbeitet, dass ihr Aussenrand 5 eine mit der Randkontur 3 kongruente Randkontur aufweist (Fig. 2a). Teil der Metallplatte 4 ist beispielsweise ein laschenartig vorstehender Anschlussbereich 6. Zusätzlich werden in die Metallplatte 4 in zwei parallelen Reihen zu je vier insgesamt acht im wesentlichen rechteckige Ausschnitte 7 eingebracht, die jeweils durch einen Innenrand 8 begrenzt sind und im späteren Hybridmodul (Fig. 10) die einzelnen Halbleiter-Leistungsmodule umschliessen.

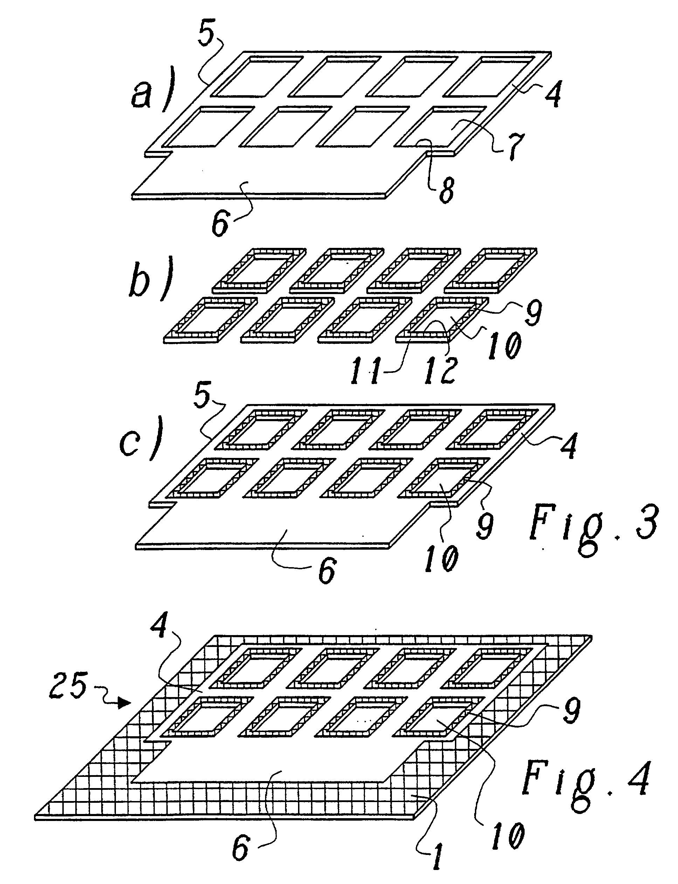

Gemäss Fig. 3 werden zu der so bearbeiteten Metallplatte 4 (Fig. 3a) acht einzelne rechteckige, rahmenförmige Isolierplatten 9 hergestellt, deren Aussenrand 11 dem Innenrand 8 der Ausschnitte 7 in der Metallplatte 4 angepasst ist (Fig. 3b). Die rahmenförmigen Isolierplatten 9 sind aus demselben Material und haben dieselbe Dicke wie die Isolierplatte 1. Sie umschliessen ihrerseits jeweils einen rechteckigen durch einen Innenrand 12 begrenzten Ausschnitt 10, in welchem im späteren Hybridmodul die einzelnen Halbleiter-Leistungsmodule angeordnet sind. Nachdem die rahmenförmigen Isolierplatten 9 in die dafür vorgesehenen Ausschnitte 7 in der Metallplatte 4 eingepasst sind (Fig. 3c) wird die Metallplatte 4 ihrerseits in den dafür vorgesehenen Ausschnitt 2 in der Isolierplatte 1 eingepasst (Fig. 4). Man erkennt sofort, dass in der in Fig. 4 gezeigten Konfiguration die Metallplatte 4 randseitig (Aussenrand und Innenrand) von plattenförmigem Isoliermaterial umschlossen ist. Die einzelnen Teile werden nun randseitig verklebt. Damit der Kleber in die schmalen, eng-tolierten Spalte zwischen Metallplatte 4 und Isolierplatten 1, 9 fliessen und diese vollständig und blasenfrei ausfüllen kann, ist es von Vorteil, die Anordnung von der Unterseite her einem Unterdruck (bzw. Vakuum) auszusetzen und den Kleber auf der Oberseite durch eine Dispensiereinrichtung oder dgl. entlang der Spalte aufzutragen. Ist die Verklebung der Plattenanordnung abgeschlossen, steht die erste einzelne, mechanisch stabile Leiterplatte 25 zur weiteren Verarbeitung zur Verfügung.

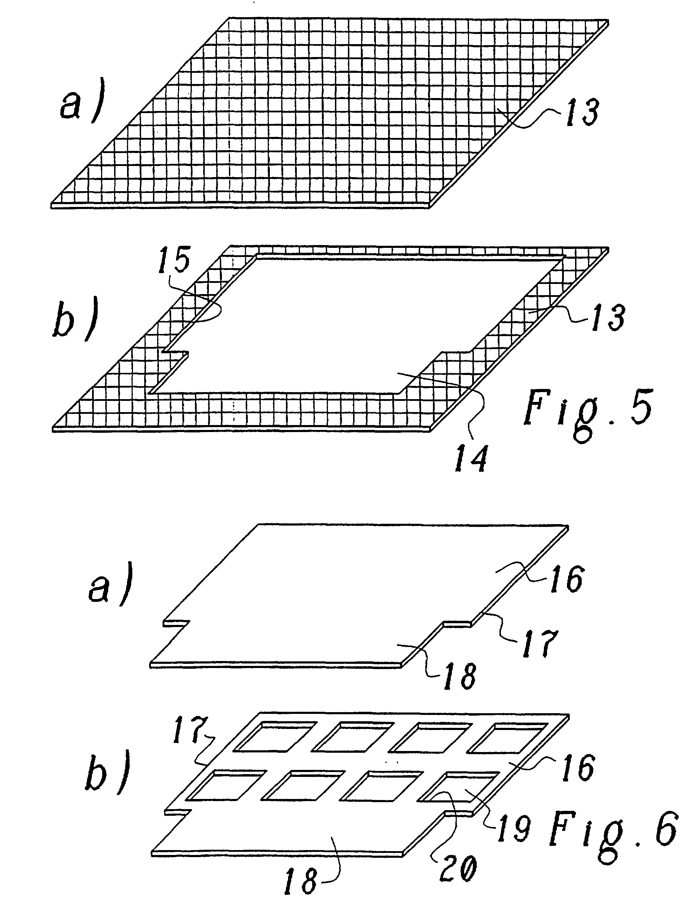

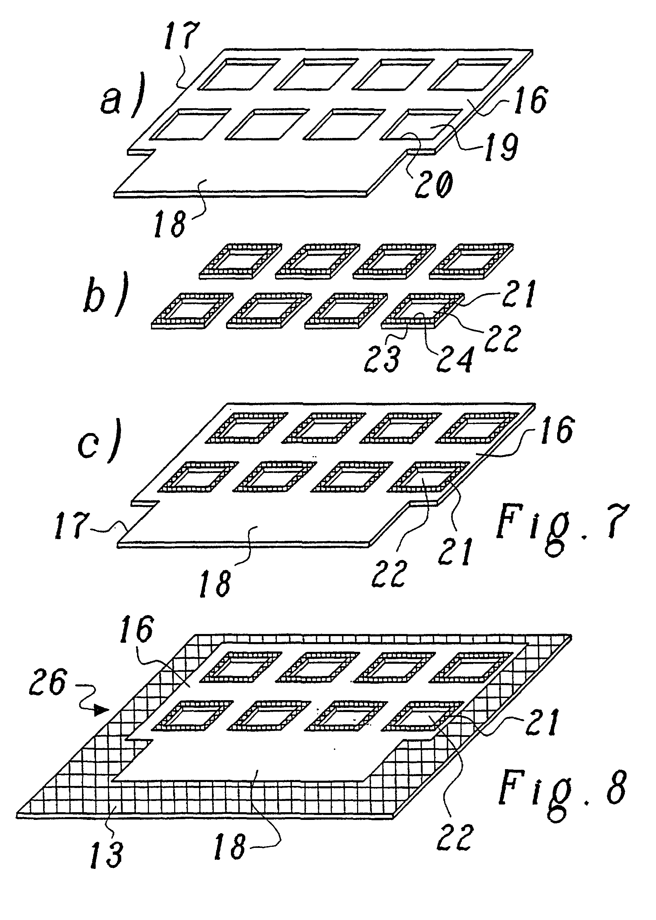

Zur Herstellung der zweiten einzelnen Leiterplatte 26 wird gemäss Fig. 5 bis 8 vollkommen analog vorgegangen, wobei in diesem Fall eine Isolierplatte 13 mit einem durch einen Innenrand 15 begrenzten Ausschnitt 14, eine Metallplatte 16 mit Aussenrand 17, Anschlusslasche 18 und durch einen Innenrand 20 begrenzten Ausschnitten 19, sowie rahmenförmige Isolierplatten 21 mit Aussenrändern 23 und durch Innenränder 24 begrenzten Ausschnitten 22 verwendet werden. Um den stufigen Aufbau im Bereich der Ausnehmungen beim späteren Hybridmodul zu erreichen, sind die Ausschnitte 19 und 22 zumindest in einer Achse kleiner ausgebildet als die Ausschnitte 7 und 10. Die fertig verklebte einzelne Leiterplatte 26 hat dann die in Fig. 8 dargestellte Form. Auch bei dieser Leiterplatte 26 sind alle Ränder der Metallplatte 16 durch plattenförmiges Isoliermaterial nach aussen hin abgedeckt.

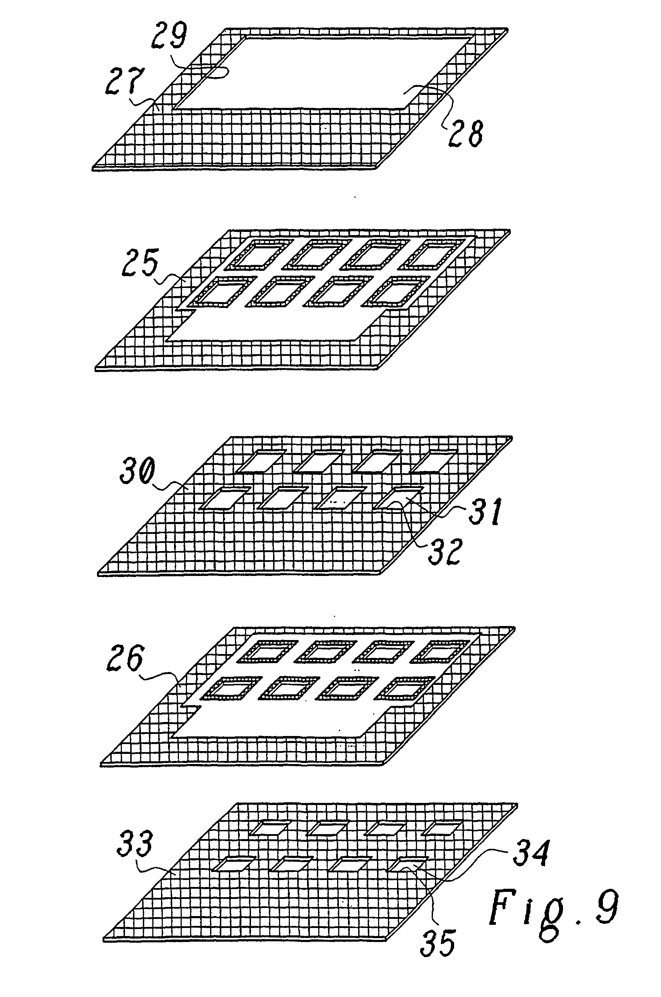

Die beiden einzelnen Leiterplatten 25 und 26 werden schliesslich (Fig. 9) zusammen mit weiteren Isolierplatten 27, 30 und 33 abwechselnd übereinander zu einem Stapel aufgeschichtet und miteinander vollflächig verklebt. Auch die Isolierplatten 27, 30 und 33 sind dabei vorzugsweise aus demselben gewebeverstärkten Isoliermaterial wie die Isolierplatten 1, 9, 13 und 21. Sie weisen an den entsprechenden Stellen ebenfalls von Innenrändern 29, 32, 35 begrenzte Ausschnitte 28, 31, 34 zur Aufnahme der Leistungsmodule auf. Der fertig verklebte Stapel ergibt schliesslich die mehrlagige Leiterplatte 36, wie sie in Fig. 10 im Schnitt gezeigt und weiter oben erläutert worden ist.

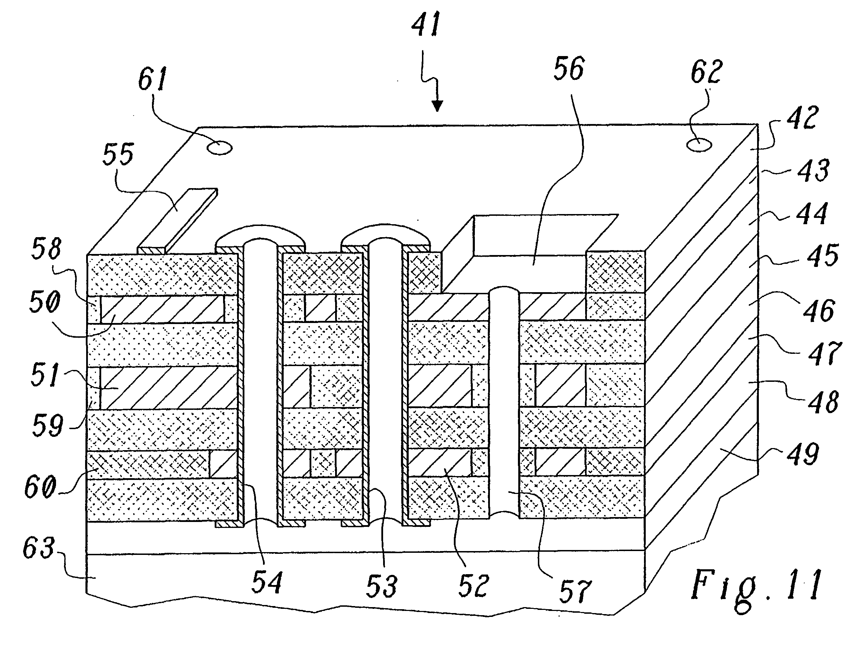

Das in den Fig. 1 bis 10 beschriebene Ausführungsbeispiel zeigt einen besonders einfachen Aufbau, bei dem die mehrlagige Leiterplatte 36 lediglich zwei einzelne Leiterplatten 25, 26 mit jeweils nur einer Metallplatte 4, 16 und ohne weitere leitende Verbindungen aufweist. Im Rahmen der Erfindung können jedoch auch wesentlich komplizierter aufgebaute Leiterplatten verwirklicht werden, bei denen nicht nur mehr leitende Lagen, sondern innerhalb der leitenden Lagen auch kompliziertere Leiterstrukturen und zwischen den leitenden Lagen elektrische Verbindungen vorhanden sein können. Ein entsprechendes Ausführungsbeispiel ist in Fig. 11 ausschnittweise wiedergegeben. Die mehrlagige Leiterplatte 41 hat in diesem Fall insgesamt acht Lagen mit drei einzelnen Leiterplatten 43, 45 und 47 und fünf Isolierplatten 42, 44, 46, 48 und 49. Innerhalb der einzelnen Leiterplatten 43, 45 und 47 sind relativ komplizierte Strukturen von Metallplatten 50, 51 und 52 untergebracht, die am Aussenrand von entsprechenden Isolierplatten 58, 59 und 60 umgeben sind. Die einzelnen Lagen der mehrlagigen Leiterplatte 41 sind in diesem Beispiel unterschiedlich dick. Zusätzlich sind in der Leiterplatte 41 Durchkontaktierungen 53 und 54 zwischen den einzelnen Metallplatten 50, 51 und 52 der leitenden Lagen und zu den Oberflächen der Leiterplatte 41 hin vorgesehen. Auf der Oberseite können dann entsprechend Leiterbahnen 55 aufgebracht sein, die z.B. SMD-Bauelemente aufnehmen oder anderweitig verwendet werden. Auch hier können Ausnehmungen 56 angeordnet sein, die den Zugang zu der darunterliegenden Metallplatte 50 ermöglichen. Weiterhin ist es denkbar, durch den Stapel hindurchgehende Bohrungen 57 vorzusehen, durch welche beispielsweise Drähte oder Schraubbolzen geführt bzw. durchgesteckt werden können. Schliesslich können isolierte Befestigungsbohrungen 61, 62 vorgesehen werden, mittels derer die Leiterplatte 41 zusammen mit einem darunterliegenden Kühlelement 63 am Einsatzort befestigt werden kann.

Insgesamt ergibt sich mit der Erfindung eine mehrlagige Leiterplatte, welche die folgenden Vorteile aufweist:
- es wird eine vollständige Isolation der Leiterbahnen nach aussen erreicht
- es wird eine hohe Teilentladungsaussetzspannung erreicht
- es wird eine hohe Zuverlässigkeit gegenüber Umwelteinflüssen (Temperatur, Luftfeuchtigkeit, Chemikalien) erreicht
- die geometrischen Abmasse sind genau einstellbar, so dass sich berechenbare konstante und induktionsarme elektrische Verbindungen ergeben
- es wird eine hohe Stabilität und Beständigkeit erreicht
- Gewebeverstärkungen in den Isolierplatten ergeben an die Cu-Leiter angepasste Ausdehnungskoeffizienten und verhindern Delaminationen
- ein zusätzliches Gehäuse kann bei Modulaufbauten unter Umständen entfallen
- viele Vorteile von Standard-Multilayer-Leiterplatten (Durchmetallisierungen, Einpresstechnik, Bestückung, Schriftdruck, Entwicklung mit Leiterplatten-CAD-Systemen) können übernommen werden
- es können zusätzliche Metallagen zur Verbesserung des EMC-Verhaltens (Abschirmung) vorgesehen werden.

### BEZEICHNUNGSLISTE

- 1: Isolierplatte
- 2: Ausschnitt (Isolierplatte 1)
- 3: Innenrand (Ausschnitt 2)
- 4: Metallplatte (Cu)
- 5: Aussenrand (Metallplatte 4)
- 6: Anschlussbereich
- 7: Ausschnitt (Metallplatte 4)
- 8: Innenrand (Ausschnitt 7)
- 9: Isolierplatte
- 10: Ausschnitt (Isolierplatte 9)
- 11: Aussenrand (Isolierplatte 9)
- 12: Innenrand (Ausschnitt 10)
- 13: Isolierplatte
- 14: Ausschnitt (Isolierplatte 13)
- 15: Innenrand (Ausschnitt 14)
- 16: Metallplatte (Cu)
- 17: Aussenrand (Metallplatte 16)
- 18: Anschlussbereich
- 19: Ausschnitt (Metallplatte 16)
- 20: Innenrand (Ausschnitt 19)
- 21: Isolierplatte
- 22: Ausschnitt (Isolierplatte 21)
- 23: Aussenrand (Isolierplatte 21)
- 24: Innenrand (Ausschnitt 22)
- 25,26: Leiterplatte
- 27,30,33: Isolierplatte
- 28,31,34: Ausschnitt
- 29, 32, 35: Innenrand (Ausschnitt)
- 36,41: mehrlagige Leiterplatte
- 37: Kühlkörper
- 38,39: Leistungsmodul (Halbleiter)
- 40: Anschlusslasche
- 42,44,46: Isolierplatte
- 43,45,47: Leiterplatte
- 48,49: Isolierplatte
- 50, 51, 52: Metallplatte
- 53,54: Durchkontaktierung
- 55: Leiterbahn
- 56: Ausnehmung
- 57: Bohrung
- 58, 59, 60: Isolierplatte
- 61,62: Befestigungsbohrung (isoliert)
- 63: Kühlelement
- D: Dicke (Leiterplatte, Metallplatte)

## Patentansprüche

1. Mehrlagige Leiterplatte (36, 41) für hohe Spannungen und hohe Ströme, bei welcher Leiterplatte (36, 41) eine Mehrzahl von einzelnen Leiterplatten (25, 26; 43, 45, 47) und ersten Isolierplatten (27, 30, 33; 42, 44, 46, 48, 49) in einem Stapel übereinander angeordnet und miteinander fest verbunden sind, wobei innerhalb einer einzelnen Leiterplatte (25, 26; 43, 45, 47) als Leiter jeweils wenigstens eine Metallplatte (4, 16; 50, 51, 52) vorgesehen ist, **dadurch gekennzeichnet, dass** die wenigstens eine Metallplatte (4, 16; 50, 51, 52) jeweils an ihrem Aussenrand (5, 17) über den gesamten Umfang von einer zweiten Isolierplatte (1 13; 58, 59, 60) formschlüssig umgeben ist.

2. Leiterplatte nach Anspruch 1, **dadurch gekennzeichnet, dass** die wenigstens eine Metallplatte (4, 16) wenigstens einen von einem Innenrand (8 bzw. 20) begrenzten Ausschnitt (7 bzw. 19) aufweist, und dass der Innenrand (8 bzw. 20) des wenigstens einen Ausschnitts (7 bzw. 19) eine dritte Isolierplatte (9 bzw. 21) formschlüssig umschliesst.

3. Leiterplatte nach einem der Ansprüche 1 und 2, **dadurch gekennzeichnet, dass** die zweiten bzw. dritten Isolierplatten (1, 13; 58, 59, 60 bzw. 9, 21) einstückig ausgebildet sind.

4. Leiterplatte nach einem der Ansprüche 1 bis 3, **dadurch gekennzeichnet, dass** die zweiten bzw. dritten Isolierplatten (1, 13; 58, 59, 60 bzw. 9, 21) dieselbe Dicke (D2) aufweisen wie die Metallplatten (4, 16; 50, 51, 52).

5. Leiterplatte nach einem der Ansprüche 1 bis 4, **dadurch gekennzeichnet, dass** die Metallplatten (4, 16; 50, 51, 52) aus Cu und die ersten und zweiten bzw. dritten Isolierplatten (27, 30, 33 bzw. 1, 13; 58, 59, 60 bzw. 9, 21) aus einem faserverstärkten Isoliermaterial, vorzugsweise einem gewebeverstärkten Epoxydharz oder einer gewebeverstärkten Keramik, bestehen.

6. Leiterplatte nach einem der Ansprüche 1 bis 5, **dadurch gekennzeichnet, dass** die Metallplatten (4, 16; 50, 51, 52) an ihrem Aussenrand (5, 17) bzw. Innenrand (8, 20) mit den zweiten Isolierplatten (1, 13; 58, 59, 60) bzw. dritten Isolierplatten (9, 21) fest verbunden, insbesondere verklebt, sind.

7. Leiterplatte nach einem der Ansprüche 1 bis 6, **dadurch gekennzeichnet, dass** zwischen den Metallplatten (50, 51, 52) unterschiedlicher Lagen der Leiterplatte (41) bzw. zwischen den Metallplatten (50, 51, 52) und den Oberflächen der Leiterplatte (41) Durchkontaktierungen (53, 54) vorgesehen sind.

8. Verfahren zum Herstellen einer mehrlagigen Leiterplatte nach einem der Ansprüche 1 bis 7, **dadurch gekennzeichnet, dass** in einem ersten Schritt die durch einen Aussenrand (5, 17) mit vorgegebener Randkontur begrenzten Metallplatten (4, 16) und die mit einem durch einen Innenrand (3, 15) mit entsprechender Randkontur begrenzten Ausschnitt (2, 14) zur formschlüssigen Aufnahme der Metallplatten (4, 16) versehenen zweiten Isolierplatten (1, 13) bereitgestellt werden, dass in einem zweiten Schritt die Metallplatten (4 bzw. 16) jeweils in den dafür vorgesehenen Ausschnitt (2 bzw. 14) der entsprechenden zweiten Isolierplatte (1 bzw. 13) eingepasst werden und zusammen mit der entsprechenden zweiten Isolierplatte (1 bzw. 13) jeweils eine einzelne Leiterplatte (25 bzw. 26) bilden, und dass in einem dritten Schritt die so gebildeten einzelnen Leiterplatten (25, 26) zusammen mit ersten Isolierplatten (27, 30, 33) in einem Stapel angeordnet und miteinander fest verbunden werden.

9. Verfahren nach Anspruch 8, **dadurch gekennzeichnet, dass** in dem ersten Schritt Metallplatten (4, 16) bereitgestellt werden, die zusätzlich wenigstens einen von einem Innenrand (8 bzw. 20) mit vorgegebener Randkontur begrenzten Ausschnitt (7 bzw. 19) aufweisen, dass in dem ersten Schritt weiterhin dritte Isolierplatten (9 bzw. 21) mit einem Aussenrand (11 bzw. 23) mit einer der Randkontur der Ausschnitte (7 bzw. 19) angepassten Randkontur bereitgestellt werden, und dass in dem zweiten Schritt die dritten Isolierplatten (9 bzw. 21) jeweils in den dafür vorgesehenen Ausschnitt (7 bzw. 19) der Metallplatten (4 bzw. 16) formschlüssig eingepasst werden.

10. Verfahren nach einem der Ansprüche 8 und 9, **dadurch gekennzeichnet, dass** die Metallplatten (4, 16) mit den zweiten bzw. dritten Isolierplatten (1, 13 bzw. 9, 21) vor dem dritten Schritt zur Bildung einer einheitlichen einzelnen Leiterplatte (25 bzw. 26) randseitig miteinander verklebt werden.

11. Verfahren nach Anspruch 10, **dadurch gekennzeichnet, dass** die randseitige Verklebung unter Vakuum erfolgt.

12. Verfahren nach einem der Ansprüche 8 bis 11, **dadurch gekennzeichnet, dass** der Stapel aus den einzelnen Leiterplatten (25, 26) und ersten Isolierplatten (27, 30, 33) im dritten Schritt miteinander ganzflächig verklebt wird.

## Claims

1. A multilayer printed circuit board (36, 41) for high voltages and high currents in which printed circuit board (36, 41) a plural number of individual printed circuit boards (25, 26; 43, 45, 47) and first insulating plates (27, 30, 33; 42, 44, 46, 48, 49) are arranged one on top of the other in a stack and are firmly interconnected, with at least one metal plate (4, 16; 50, 51, 52) being provided as a conductor within each individual printed circuit board (25, 26; 43, 45, 47), **characterised in that** the metal plate (4, 16; 50, 51, 52) of which there is at least one, at its exterior margin (5, 17) is surrounded with a positive fit along its entire circumference by a second insulating plate (1, 13; 58, 59, 60).

2. A printed circuit board according to claim 1, **characterised in that** the metal plate (4, 16) of which there is at least one, comprises a cutout (7 or 19) of which there is at least one, which is delimited by an interior margin (8 or 20), and **in that** the interior margin (8 or 20) of the cutout (7 or 19) of which there is at least one, surrounds with a positive fit a third insulating plate (9 or 21).

3. A printed circuit board according to one of claims 1 or 2, **characterised in that** the second or third insulating plates (1, 13; 58, 59, 60 or 9, 21) are constructed in one piece.

4. A printed circuit board according to one of claims 1 to 3, **characterised in that** the second or third insulating plates (1, 13; 58, 59, 60 or 9, 21) comprise the same thickness (D2) as the metal plates (4, 16; 50, 51, 52).

5. A printed circuit board according to one of claims 1 to 4, **characterised in that** the metal plates (4, 16; 50, 51, 52) comprise Cu and the first and second or third insulating plates (27, 30, 33 or 1, 13; 58, 59, 60 or 9, 21) comprise a fibre-reinforced insulation material, preferably a fabric-reinforced epoxy resin or a fabric-reinforced ceramic.

6. A printed circuit board according to one of claims 1 to 5, **characterised in that** the exterior margins (5, 17) or interior margins (8, 20) of the metal plates (4, 16; 50, 51, 52) are firmly connected, in particular bonded, to the second insulating plates (1, 13; 58, 59, 60) or the third insulating plates (9, 21).

7. A printed circuit board according to one of claims 1 to 6, **characterised in that** between the metal plates (50, 51, 52) of different layers of the printed circuit board (41) or between the metal plates (50, 51, 52) and the surfaces of the printed circuit board (41) through-hole platings (53, 54) are provided.

8. A method for producing a multilayer printed circuit board according to one of claims 1 to 7, **characterised in that** in a first step the metal plates (4, 16) which are delimited by an exterior margin (5, 17) with a defined margin contour, and the second insulating plates (1, 13) with a cutout (2, 14) delimited by an interior margin (3, 15) with a respective marginal contour for accommodating the metal plates (4, 16) with a positive fit, are provided; that in a second step the metal plates (4 or 16) are fitted into the cutout (2 or 14) provided on the respective second insulating plate (1 or 13) and together with the respective second insulating plate (1 or 13) form a single printed circuit board (25 or 26); and **in that** in a third step the individual printed circuit boards (25, 26) formed in this way, together with first insulating plates (27, 30, 33) are arranged in a stack and are firmly interconnected.

9. A method according to claim 8, **characterised in that** in the first step, metal plates (4, 16) are provided which additionally comprise at least one cutout (7 or 19) delimited by an interior margin (8 or 20) with defined marginal contour; that in the first step furthermore third insulating plates (9 or 21) with an exterior margin (11 or 23) with a marginal contour matching the marginal contour of the cutouts (7 or 19), are provided; and that in the second step the third insulating plates (9 or 21) are fitted, with a positive fit, into the cutout (7 or 19) of the metal plates (4 or 16) provided for this.

10. A method according to one of claims 8 or 9, **characterised in that** prior to the third step to form a uniform individual printed circuit board (25 or 26), the metal plates (4, 16) are bonded at the margin to the second or third insulating plates (1, 13, or 9, 21).

11. A method according to claim 10, **characterised in that** bonding at the margin takes place in a vacuum.

12. A method according to one of claims 8 to 11, **characterised in that** in the third step the stacks of individual printed circuit boards (25, 26) and first insulating plates (27, 30, 33) are bonded together on their entire mating surfaces.

## Revendications

1. Plaque conductrice (36, 41) multicouches pour des tensions élevées et courants forts, carte imprimée (36, 41) sur laquelle un grand nombre de plaques conductrices (25, 26; 43, 45, 47) et de premières plaques isolantes (27, 30, 33; 42, 44, 46, 48, 49) sont disposées les unes au-dessus des autres dans une pile et sont reliées de façon fixe entre elles, respectivement au moins une plaque métallique (4, 16; 50, 51, 52) étant prévue à l'intérieur d'une plaque conductrice (25, 26; 43, 45, 47) individuelle comme conducteur, **caractérisée en ce que** la au moins une plaque métallique (4, 16; 50, 51, 52) est entourée par complémentarité de forme respectivement sur son bord extérieur (5, 17) sur l'ensemble de la périphérie par une deuxième plaque isolante (1, 13; 58, 59, 60).

2. Plaque conductrice selon la revendication 1, **caractérisée en ce que** la au moins une plaque métallique (4, 16) présente au moins une découpe (7 ou 19) limitée par un bord intérieur (8 ou 20), et **en ce que** le bord intérieur (8, ou 20) de la au moins une découpe (7 ou 19) entoure une troisième plaque isolante (9 ou 21) par complémentarité de forme.

3. Plaque conductrice selon l'une des revendications 1 et 2, **caractérisée en ce que** les deuxièmes ou troisièmes plaques isolantes (1, 13; 58, 59, 60 ou 9, 21) sont conçues d'un seul tenant.

4. Plaque conductrice selon l'une quelconque des revendications 1 à 3, **caractérisée en ce que** les deuxièmes ou troisièmes plaques isolantes (1, 13; 58, 59, 60 ou 9, 21) présentent la même épaisseur (D2) que les plaques métalliques (4, 16; 50, 51, 52).

5. Plaque conductrice selon l'une quelconque des revendications 1 à 4, **caractérisée en ce que** les plaques métalliques (4, 16; 50, 51, 52) sont en cuivre et les premières et deuxièmes ou troisièmes plaques isolantes (27, 30, 33 ou 1, 13; 58, 59, 60 ou 9, 21) sont à base d'un matériau isolant renforcé avec de la fibre, de préférence une résine époxy renforcée de tissu ou une céramique renforcée de tissu.

6. Plaque conductrice selon l'une quelconque des revendications 1 à 5, **caractérisée en ce que** les plaques métalliques (4, 16; 50, 51, 52) sont reliées de façon fixe, en particulier collées, sur leur bord extérieur (5, 17) ou leur bord intérieur (8, 20) avec les deuxièmes plaques isolantes (1, 13; 58, 59, 60) ou troisièmes plaques isolantes (9, 21).

7. Plaque conductrice selon l'une quelconque des revendications 1 à 6, **caractérisée en ce que** des connexions transversales (53, 54) sont prévues entre les plaques métalliques (50, 51, 52) de différentes couches de la plaque conductrice (41) ou entre les plaques métalliques (50, 51, 52) et les surfaces de la plaque conductrice (41).

8. Procédé pour fabriquer une plaque conductrice multicouches selon l'une quelconque des revendications 1 à 7, **caractérisé en ce que** les plaques métalliques (4, 16), limitées par un bord extérieur (5, 17) avec un contour périphérique prédéfini et les deuxièmes plaques isolantes (1, 13) pourvues d'une découpe (2, 14), limitée par un bord intérieur (3, 15) avec un contour périphérique approprié, pour le logement mécanique des plaques métalliques (4, 16) sont mises à disposition dans une première étape, **en ce que** dans une deuxième étape les plaques métalliques (4 ou 16) sont adaptées respectivement dans la découpe (2 ou 14) prévue à cet effet de la deuxième plaque isolante correspondante et forment conjointement avec la deuxième plaque isolante (1 ou 13) correspondante respectivement une plaque conductrice (25 ou 26) individuelle, et **en ce que** dans une troisième étape les plaques conductrices (25 ou 26) individuelles ainsi formées sont disposées conjointement avec des premières plaques isolantes (27, 30, 33) dans une pile et sont reliées de façon fixe entre elles.

9. Procédé selon la revendication 8, **caractérisé en ce que** dans la première étape des plaques métalliques (4, 16) sont mises à disposition et qu'elles présentent en supplément au moins une découpe (7 ou 19) limitée par un bord intérieur (8 ou 20) avec un contour périphérique prédéfini, **en ce que** dans la première étape également des troisièmes plaques isolantes (9 ou 21) avec un bord extérieur (11 ou 23) avec un contour périphérique adapté au contour périphérique des découpes (7 ou 19) sont mises à disposition et **en ce que**, dans la deuxième étape, les troisièmes plaques isolantes (9 ou 21) sont ajustées par complémentarité de forme respectivement dans la découpe (7 ou 19) prévue à cet effet des plaques métalliques (4 ou 16).

10. Procédé selon l'une quelconque des revendications 8 ou 9, **caractérisé en ce que** les plaques métalliques (4, 16) sont collées entre elles côté bord avec les deuxièmes ou troisièmes plaques isolantes (1, 13 ou 9, 21) avant la troisième étape pour former une plaque conductrice (25 ou 26) individuelle homogène.

11. Procédé selon la revendication 10, **caractérisé en ce que** le collage côté bord s'effectue sous vide.

12. Procédé selon l'une quelconque des revendications 8 à 11, **caractérisé en ce que** la pile constituée des plaques conductrices (25, 26) individuelles et des premières plaques isolantes (27, 30, 33) sont collées sur toute la surface les unes avec les autres au cours de la troisième étape.
